# EUROPÄISCHE PATENTSCHRIFT

(11) **EP 0 856 878 B1**
(45) Veröffentlichungstag und Bekanntmachung des Hinweises auf die Patenterteilung: **08.08.2007**
(21) Anmeldenummer: 98100727.1
(22) Anmeldetag: 16.01.1998
(51) Int. Cl.: H01L 21/02, H01L 21/768, H01L 21/3205, C23C 16/18

(54) **Verfahren zum Erzeugen einer edelmetallhaltigen Struktur auf einem Halbleiterbauelement**
Method of manufacturing a structure comprising a precious metal on a semiconductor element
Méthode de fabrication d'une structure comprenant un métal précieux sur un dispositif semiconducteur

(30) Priorität: 29.01.1997 DE 19703205
(43) Veröffentlichungstag der Anmeldung: 05.08.1998
(73) Patentinhaber: Qimonda AG, 81739 München (DE)
(72) Erfinder: Mazure-Espejo, Carlos, Dr., 85604 Zorneding (DE); Weinrich, Volker, Dr., 81549 München (DE)
(74) Vertreter: Epping - Hermann - Fischer

(56) Entgegenhaltungen:
- EP-A- 0 128 102
- DE-A- 2 928 256
- US-A- 5 494 704
- US-A- 5 589 425
- GARRIDO C ET AL: "FORMATION OF PT INTERCONNECTION LINES AND PERIODIC STRUCTURES" JAPANESE JOURNAL OF APPLIED PHYSICS, Bd. 32, Nr. 3A, PART 01, 1. März 1993, Seiten 1312-1316, XP000415028

## Beschreibung

Die vorliegende Erfindung betrifft ein verfahren zum Erzeugen einer edelmetallhaltigen Struktur auf einer Unterlage wie etwa einem Halbleiterwafer, und zwar insbesondere die Erzeugung einer sehr feinen Struktur mit einer Detailgröße im Mikrometer-Bereich und darunter. Des weiteren betrifft die Erfindung ein Halbleiterbauelement mit einer solchen edelmetallhaltigen Struktur.

Seit einigen Jahren besteht in der Halbleiter-Industrie ein großes Interesse an derartigen Verfahren. Ein Grundproblem bei der fortschreitenden Miniaturisierung von integrierten Schaltungen ist die Integration von Kondensatoren. Da die Kapazität ihrer Querschnittsfläche und damit der von ihnen belegten Substratoberfläche proportional ist, lassen sie sich nicht in derselben Weise miniaturisieren wie z. B. Transistoren.

Ein Ansatz zur Lösung dieses Problems besteht darin, als Dielektrikum des Kondensators nicht mehr einen gesperrt betriebenen P-N-Übergang oder die in der MIS- bzw. MOS-Technik stets vorhandene Isolierschicht (Siliziumdioxid und/oder Siliziumnitrid) zu verwenden, sondern gezielt eine dielektrische Schicht aus einem Material mit höherer Dielektrizitätskonstante auf das Halbleitersubstrat aufzubringen. Hierfür werden insbesondere oxidkeramische Materialien wie z. B. Blei-Zirkonat-Titanat (PbZr₁₋ₓTiₓO₃, PZT), Barium-Strontium-Titanat ((Ba,Sr)TiO₃) oder Strontium-Wismut-Tantalat (SrBi₂Ta₂O₉) in Betracht gezogen. Verwendet man z. B. anstelle von Si₃N₄ mit der Dielektrizitätskonstante ε = 7 ein Material wie PZT mit einer Dielektrizitätskonstante ε = 1400, so läßt sich bei gleichbleibender Kapazität gleichzeitig die Schichtdicke des Dielektrikums um einen Faktor 10 erhöhen, um dessen Durchbruchverhalten zu verbessern, und die Fläche des Kondensators um einen Faktor 20 verringern.

Bei der Verarbeitung oxidkeramischer Materialien treten jedoch Probleme auf. Schichten aus diesen Materialien können durch Sputtern, Gasphasenabscheidung oder Sol-Gel-Verfahren erzeugt werden. Die Abscheidung muß in einer sauerstoffhaltigen Atmosphäre stattfinden und die Sol-Gel-Schicht muß in einer Sauerstoffatmosphäre getempert werden. Beides führt dazu, daß ein an das Dielektrikum angrenzendes Elektrodenmaterial aus Polysilicium oder Siliciden oxidiert, wodurch seine Leitfähigkeit und damit die Zuverlässigkeit der gesamten Schaltung beeinträchtigt wird. Um dieses Problem zu lösen, wurde vorgeschlagen, Platin als Elektrodenmaterial zu verwenden, da es beim Tempern oder Abscheiden der dielektrischen Schicht nicht durch Sauerstoff angegriffen wird.

Ein erheblicher Nachteil bei der Verwendung von Platin als Elektrodenmaterial besteht darin, daß diese Verfahren für eine Mikrostrukturierung noch nicht ausreichend beherrscht werden. Nishikawa et al. beschreiben in Jpn. J. Appl. Phys. 32 (1993) Seiten 6102 - 6108 Verfahren zum Ätzen von Platinschichten mit Mikrowellen- und Elektronzyklotronresonanzplasmen. Die Autoren weisen auf die besonderen Schwierigkeiten hin, die beim Bearbeiten von Platin mit Submikrometergenauigkeit auftreten.

Versuche, Platin durch energiereiche Ionen anisotrop zu ätzen, sind bei A. Cofer, VMIC Conference 1995, 638 und A. Cofer und B. Vail, Tegal European Plasma Seminar Proceedings 1995, 33 beschrieben. Mit diesem Verfahren können Platinstrukturen mit einer Kantensteilheit von bis zu 68° geätzt werden. Im Vergleich zu den mit Materialien wie Si und Al erreichbaren Werten ist dieses Ergebnis noch unbefriedigend.

Das Problem der Ätzverfahren ist, dass das abgeätzte Platin keine flüchtigen Verbindungen eingeht, die sich aus dem Reaktionsbereich leicht entfernen ließen, sondern sich in erheblichem Maße auf der Oberfläche wieder ablagert. Beide Effekte begrenzen die beim Ätzen von Platin erreichbare Auflösung.

Die Druckschrift US 5,589,425 beschreibt ein Verfahren zur Abscheidung von Metallschichten, bei dem eine Verbindung aus Dimethyl-Gold-Hexafluoracetylacetonat (DMAU (hfa)) mit einem ersten Substratbereich aus Kupfer oder einer anderen Substanz, die mit der Hexafluoracetylacetonatverbindung eine Reaktion eingeht, und einem zweiten Bereich des Substrats, der keine Reaktion mit der Hexafluoracetylacetonatverbindung zeigt, in Kontakt gebracht wird. Der zweite Bereich weist beispielsweise Substanzen wie Au, W, Pt, Ti, TiN, SiN oder SiO₂ auf wobei das Gold der DMAu (hfa) -Verbindung auf dem zweiten Bereich des Substrats abgeschieden wird. Durch die Reaktion des Cu mit dem hfa wird im ersten Bereich des Substrats das Cu abgedeckt, so dass eine Abscheidung von Gold in diesem Bereich vermieden wird.

Aufgabe der Erfindung ist, eine neuartiges Verfahren zum Erzeugen einer edelmetallhaltigen Struktur wie etwa einer Platinstruktur auf einer Unterlage anzugeben, mit dem auf einfachen Wege eine Auflösung erreicht werden kann, die der mit leichter zu bearbeitenden Materialien erreichten gleichkommt.

Die Aufgabe wird gelöst durch ein Verfahren nach Anspruch 1. Im ersten Verfahrensschritt wird gemäß der Erfindung auf der Unterlage eine Vorstruktur aus einem Nichtedelmetall erzeugt, deren Gestalt derjenigen der gewünschten edelmetallhaltigen Struktur entspricht. Zum Erzeugen der Vorstruktur können beliebige, gut beherrschte herkömmliche Verfahren eingesetzt werden. Die Unterlage mit der Vorstruktur wird in eine Atmosphäre eingebracht, die eine gasförmige metallorganische Verbindung eines Edelmetalls enthält, welches die fertige Struktur bilden oder in ihr enthalten sein soll wobei die Verbindung Acetylacetonat enthält. An der Oberfläche der Vorstruktur findet eine Festkörper-Gasphasen-Reaktion statt, in deren Verlauf aufgrund der unterschiedlichen Bindungspotentiale von Edel- und Nichtedelmetall Edelmetall aus der Gasphase auf der Vorstruktur abgeschieden wird, und das Nichtedelmetall der Vorstruktur in entsprechender Menge eine gasförmige Verbindung bildet. Das abgeschiedene Edelmetall diffundiert ins Innere der Vorstruktur, im Gegenzug rückt Nichtedelmetall an die Oberfläche nach und reagiert dort. Bei diesem gewissermaßen Atom für Atom stattfindenden Materialaustausch zwischen der Vorstruktur und der Reaktionsgasatmosphäre bleibt die Gestalt der Vorstruktur exakt erhalten.

Die Austauschreaktion kann insbesondere bei feinen Strukturen so lange fortgesetzt werden, bis im wesentlichen alle Nichtedelmetallatome an die Oberfläche der Struktur diffundiert und dort abreagiert sind, so daß das Nichtedelmetall im wesentlichen vollständig durch das Edelmetall ersetzt ist. Um die gewünschte Oxidationsbeständigkeit zu erzielen, kann es aber bereits genügen, wenn lediglich ein vorgegebenes Legierungsverhältnis zwischen den Edelmetallen und den Nichtedelmetallen erreicht ist. Bei gröberen Strukturen kann es ausreichen, wenn lediglich eine Oberflächenschicht vorgegebener Dicke durch das Edelmetall ersetzt wird.

Über die Prozeßtemperatur läßt sich die Diffusionsgeschwindigkeit der Atome in der Vorstruktur und damit der Konzentrationsgradient der Edelmetallatome zum Inneren der Vorstruktur hin bzw. die Dicke der Edelmetallschicht steuern.

Als Edelmetall kommen beispielsweise Platin, Ruthenium und/oder Iridium in Frage, Nichtedelmetall kann ein beliebiges, mit mikrolithographischen Verfahren strukturierbares Metall wie etwa Aluminium oder auch Polysilicium sein. Als gasförmige Reaktionspartner der Austauschreaktion können metallorganische Verbindungen, insbesondere Acetylacetonate verwendet werden.

Das erfindungsgemäße Halbleiterbauelement kann ein oder mehrere nach dem erfindungsgemäßen Verfahren erzeugte Edelmetallstrukturen aufweisen. Wenn das Halbleiterbauelement eine oxidkeramische Schicht, z. B. aus Strontiumwismuttantalat, Bariumstrontiumtitanat oder Bleizirkonattitanat aufweist, die das Dielektrikum eines Kondensators bildet, so muß als eine Elektrode des Kondensators eine Edelmetallstruktur zwischen dem Substrat und der oxidkeramischen Schicht vorgesehen werden, da konventionelle Elektroden beim Erzeugen der oxidkeramischen Schicht oxidiert werden.

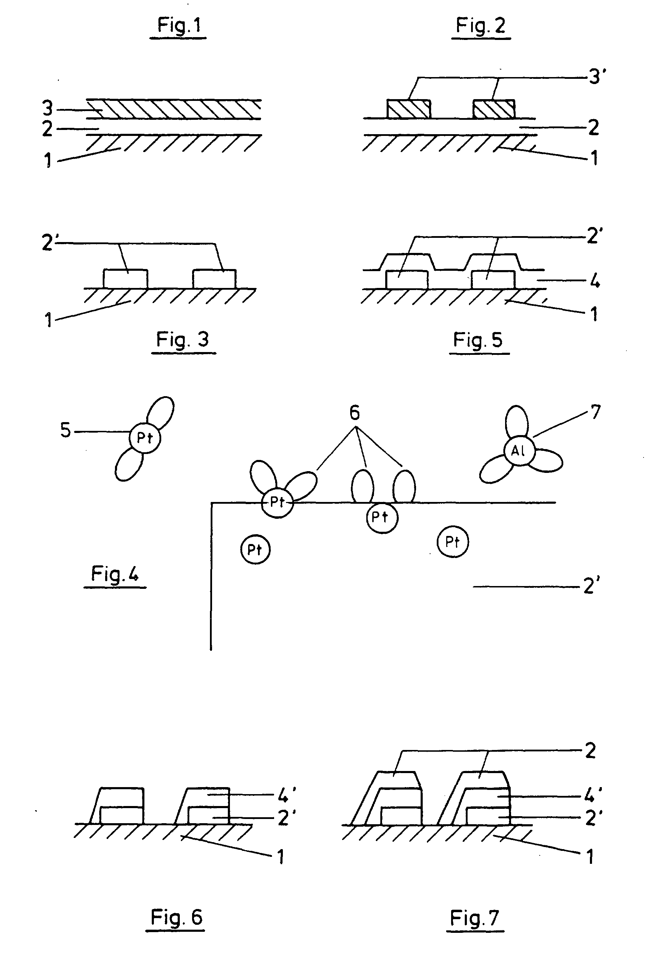

Im folgenden werden unter Bezugnahme auf die beigefügten, stark schematisierten Figuren 1 bis 7 die Herstellungsschritte für ein Halbleiterbauelement unter Verwendung des erfindungsgemäßen Verfahrens beschrieben.

Figur 1 zeigt im Schnitt einen Ausschnitt aus der Oberfläche eines Halbleiterwafers 1 mit einer Vorstruktur 2, z. B. einer aufgedampften Aluminiumschicht und einer Photoresistschicht 3. Die Photoresistschicht 3 wird belichtet. Die belichteten Teile werden durch einen Entwickler gelöst, die unbelichteten Teile 3' der Photoresistschicht bleiben stehen (Fig. 2).

Anschließend werden die unbedeckten Abschnitte der Vorstruktur 2, hier also die Aluminiumschicht, bis auf den Halbleiterwafer 1 abgeätzt, und die verbliebene Photoresistschicht 2 wird beseitigt. Auf dem Halbleiterwafer 1 bleibt die fertige Vorstruktur 2', hier aus Aluminium, zurück (Fig. 3).

Der Halbleiterwafer 1 mit der fertigen Vorstruktur 2' wird bei einer Temperatur von ca. 350° C einer Atmosphäre ausgesetzt, die Platin-Acetylacetonat enthält. Figur 4 zeigt die dabei ablaufenden Prozesse. Das Platin-Acetylacetonat sublimiert bei 170° C und zersetzt sich bei 420° C, ist also bei der gewählten Prozeßtemperatur stabil. Moleküle dieser gasförmigem Verbindung 5 lagern sich an der Oberfläche der Vorstruktur 2' an und zerfallen aufgrund des im Vergleich zu Platin niedrigeren Redoxpotentials des Aluminiums. Dabei gehen die Acetylacetonatgruppen 6 auf das Aluminium über. Es entsteht Aluminiumacetylacetonat 7. Dessen Siedepunkt liegt bei 315° C, es ist also bei der gewählten Prozeßtemperatur ebenfalls gasförmig und verläßt die Oberfläche.

Auf diese Weise wird die Oberfläche der Vorstruktur 2' mit der Zeit immer ärmer an Aluminium und reicher an Platin. Es entsteht so ein Konzentrationsgradient zwischen der Oberfläche der Vorstruktur 2' und ihrem Kern. Durch Diffusion dringt das Platin ins Innere der Vorstruktur 2' ein, während Aluminium an die Oberfläche nachrückt und dort ausgetauscht wird.

Bei einer feinen Struktur mit Schichtdicken von einigen 10 Nanometern kann auf diese Weise das Aluminium praktisch ganz gegen Platin ausgetauscht werden oder ein Legierungsverhältnis eingestellt werden, das einer der zahlreichen Intermetallphasen des Systems Aluminium/Platin entspricht, ohne daß sich dabei die Form der Vorstruktur 2' ändert.

Bei größeren Schichtdicken oder relativ niedrigen Prozeßtemperaturen ist der Diffusionsprozeß relativ weniger effizient. Bei dicken Schichten ist es dann auch nicht erforderlich, das Aluminium vollständig auszutauschen, da ein hinreichend tiefer Austausch der Oberflächenschicht genügt, um den verbleibenden Aluminiumkern vor Oxidation zu schützen.

Auf den in dieser Weise vorbereiteten Wafer kann nun eine oxidkeramische Schicht 4 abgeschieden werden (Fig. 5), um die Dielektrika 4' der Kondensatoren zu erzeugen. Diese kann, wenn nötig, in bekannter Weise maskiert und geätzt werden (Fig. 6).

Nun kann ein zweiter Zyklus des Bedampfens mit Aluminium, Maskierens und Ätzens durchgeführt werden, um auf den Dielektrika 4' eine zweite Vorstruktur 2 zu bilden (Fig. 7). An dieser Vorstruktur wird das erfindungsgemäße Verfahren abermals durchgeführt, um fertige integrierte Kondensatoren mit Platinelektroden zu erhalten.

Alternativ kann die Gegenelektrode auch ganzflächig abgeschieden und mit der Liftoff-Technik strukturiert werden. Diese Alternative ist insbesondere dann bevorzugt, wenn für die Gegenelektrode eine weniger detailreiche Struktur erforderlich ist.

## Patentansprüche

1. Verfahren zum Erzeugen einer edelmetallhaltigen Struktur (2') auf einer Unterlage (1) mit den Schritten:
(a) Erzeugen einer Vorstruktur (2) auf der Unterlage (1), die aus einem Nichtedelmetall besteht und die Gestalt der gewünschten Struktur hat,
(b) Einbringen der Unterlage mit der Vorstruktur (2) in eine Atmosphäre, die eine bei der Temperatur und unter dem Druck dieser Atmosphäre gasförmige metallorganische Verbindung (5) eines Edelmetalls enthält, wobei die Verbindung Acetylacetonat enthält,
**gekennzeichnet durch**,
(c) Einbringen von Edelmetall in die Vorstruktur **durch** Umsetzen der gasförmigen metallorganischen Verbindung (5) des Edelmetalls mit dem Nichtedelmetall in elementares Edelmetall und eine gasförmige Verbindung (7) des Nichtedelmetalls, bis eine gewünschte Menge des Nichtedelmetalls der Vorstruktur (2) **durch** das Edelmetall ersetzt ist.

2. Verfahren nach Anspruch 1,
**dadurch gekennzeichnet, daß**
die Unterlage (1) ein Halbleiterwafer ist.

3. Verfahren nach Anspruch 1 oder 2,
**dadurch gekennzeichnet, daß**
Schritt c fortgesetzt wird, bis das Nichtedelmetall im wesentlichen vollständig durch das Edelmetall ersetzt ist.

4. Verfahren nach Anspruch 1 oder 2,
**dadurch gekennzeichnet, daß**
Schritt c fortgesetzt wird, bis ein vorgegebe-nes Legierungsverhältnis zwischen dem Edelmetall und dem Nichtedelmetall erreicht ist.

5. Verfahren nach Anspruch 1 oder 2,
**dadurch gekennzeichnet, daß**
Schritt c fortgesetzt wird, bis das Edelmetall eine Schicht von vorgegebener Dicke auf der Struktur (2') bildet.

6. Verfahren nach einem der vorhergehenden Ansprüche,
**dadurch gekennzeichnet, daß**
das Edelmetall Pt und/oder Ru und/oder Ir ist.

7. Verfahren nach einem der vorhergehenden Ansprüche,
**dadurch gekennzeichnet, daß**
das Nichtedelmetall A1 und/oder Poly-Si umfasst.

8. Verfahren nach einem der vorhergehenden Ansprüche,
**dadurch gekennzeichnet, daß**
das Edelmetall Pt und das Nichtedelmetall A1 ist.

9. Verfahren nach Anspruch 8,
**dadurch gekennzeichnet, daß**
Schritt c bei einer Temperatur der Atmosphäre zwischen 330 °C. und 400 °C durchgeführt wird.

## Claims

1. Method for producing a noble metal-containing structure (2') on a substrate (1) with the steps of:
(a) producing, on the substrate (1), a preliminary structure (2) which consists of a non-noble metal and has the configuration of the desired structure;
(b) introducing the substrate with the preliminary structure (2) into an atmosphere which contains a metalorganic noble metal compound (5) that is gaseous at the temperature and under the pressure of this atmosphere, the compound containing acetylacetonate, **characterized by**
(c) introducing noble metal into the preliminary structure by converting the gaseous, metalorganic compound (5) of the noble metal with the non-noble metal into elementary noble metal and a gaseous compound (7) of the non-noble metal, until a desired amount of the non-noble metal in the preliminary structure (2) is replaced by the noble metal.

2. Method according to Claim 1, **characterized in that** the substrate (1) is a semiconductor wafer.

3. Method according to Claim 1 or 2, **characterized in that** step c is continued until the non-noble metal is substantially fully replaced by the noble metal.

4. Method according to Claim 1 or 2, **characterized in that** step c is continued until a predetermined alloy ratio between the noble metal and the non-noble metal is reached.

5. Method according to Claim 1 or 2, **characterized in that** step c is continued until the noble metal forms a layer of predetermined thickness on the structure (2').

6. Method according to one of the preceding claims, **characterized in that** the noble metal is Pt and/or Ru and/or Ir.

7. Method according to one of the preceding claims, **characterized in that** the non-noble metal comprises A1 and/or poly-Si.

8. Method according to one of the preceding claims, **characterized in that** the noble metal is Pt and the non-noble metal is A1.

9. Method according to Claim 8, **characterized in that** step c is carried out at an atmosphere temperature of between 330°C and 400°C.

## Revendications

1. Procédé de production d'une structure (2') contenant du métal précieux sur un support (1) ayant les stades :
a) on produit une structure (2) préalable sur le support (1) qui est en un métal non précieux et qui a la forme de la structure souhaitée,
b) on introduit le support ayant la structure (2) préalable dans une atmosphère qui contient un composé (5) organométallique d'un métal précieux qui est gazeux à la température et sous la pression de cette atmosphère, le composé contenant un acétylacétonate,
**caractérisé en ce que**
c) on introduit du métal précieux dans la structure préalable en faisant réagir le composé (5) organométallique gazeux du métal précieux sur le métal non précieux pour obtenir du métal précieux élémentaire et un composé (7) gazeux du métal non précieux jusqu'à ce qu'une quantité souhaitée du métal non précieux de la structure (2) antérieure soit remplacée par le métal précieux.

2. Procédé suivant la revendication 1,
**caractérisé en ce que**
le support est une tranche de semiconducteur.

3. Procédé suivant la revendication 1 ou 2,
**caractérisé en ce que**
l'on poursuit le stade c) jusqu'à ce que le métal non précieux soit remplacé sensiblement complètement par le métal précieux.

4. Procédé suivant la revendication 1 ou 2,
**caractérisé en ce que**
l'on poursuit le stade c) jusqu'à obtention d'un rapport d'alliage prescrit entre le métal précieux et le métal non précieux.

5. Procédé suivant la revendication 1 ou 2,
**caractérisé en ce que**
l'on poursuit le stade c) jusqu'à ce que le métal précieux forme une couche d'une épaisseur prescrite sur la structure (2').

6. Procédé suivant l'une des revendications précédentes,
**caractérisé en ce que**
le métal précieux est du Pt et/ou du Ru et/ou du Ir.

7. Procédé suivant l'une des revendications précédentes,
**caractérisé en ce que**
le métal non précieux comprend du Al et/ou du poly-Si.

8. Procédé suivant l'une des revendications précédentes,
**caractérisé en ce que**
le métal précieux est du Pt et le métal non précieux est de l'Al.

9. Procédé suivant la revendication 8,
**caractérisé en ce que**
l'on effectue le stade c) à une température de l'atmosphère comprise entre 330°C et 400°C.
